# EUROPÄISCHE PATENTSCHRIFT

(11) **EP 2 099 646 B1**
(45) Veröffentlichungstag und Bekanntmachung des Hinweises auf die Patenterteilung: **30.08.2017**
(21) Anmeldenummer: 07846922.8
(22) Anmeldetag: 30.11.2007
(51) Int. Cl.: B60Q 1/14, H03K 17/97

(54) **LENKSTOCKSCHALTER FÜR KRAFTFAHRZEUGE**
STEERING-COLUMN SWITCH FOR MOTOR VEHICLES
COMMUTATEUR DE COLONNE DE DIRECTION POUR VÉHICULES AUTOMOBILES

(30) Priorität: 06.12.2006 DE 102006057571
(43) Veröffentlichungstag der Anmeldung: 16.09.2009
(73) Patentinhaber: Valeo Schalter und Sensoren GmbH, 74321 Bietigheim-Bissingen (DE)
(72) Erfinder: INTINI, Onofrio, 71665 Vaihingen a.d. Enz (DE); RUETZ, Christian, 71636 Ludwigsburg (DE)
(86) Internationale Anmeldenummer: PCT/EP2007/010397
(87) Internationale Veröffentlichungsnummer: WO 2008/067954

(56) Entgegenhaltungen:
- EP-A- 1 270 328
- EP-A- 1 715 498
- DE-A1- 19 749 330
- DE-C1- 19 808 665
- US-B1- 6 175 290

## Beschreibung

Die Erfindung betrifft einen Lenkstockschalter für Kraftfahrzeuge gemäß dem Oberbegriff des Anspruchs 1. Aus der Veröffentlichung "3D-Magnetfeldsensor auf Standard-CMOS" des Fraunhofer-Instituts für integrierte Schaltungen IIS ist ein Joystick-Bedienhebel bekannt, der an einem Kugelgelenk gelagert ist und der an einem freien Ende einen Permanentmagneten trägt, der mit einem ortsfesten Magnetfeldsensor zusammenwirkt. Der Magnetfeldsensor ist in der Lage, das sich durch die Bewegung des Permanentmagneten ändernde Magnetfeld in drei Dimensionen zu erfassen. Auf diese Weise ist es möglich, die Schwenklage des Bedienhebels mit nur einem Sensor erfassen zu können. Darüber hinaus schlägt die genannte Veröffentlichung vor, den Abstand des Magneten zu dem Magnetfeldsensor ändern zu können, um einen analogen oder digitalen Bedienknopf zu schaffen. Ein für den beschriebenen Aufbau geeigneter Sensor ist beispielsweise unter der Bezeichnung "MLX90316" der Fa. Melexis Microelectronic Integrated Systems bekannt.

Das Dokument EP 1 270 328 A2 beschreibt einen Lenkstockschalter, der neben zwei Schwenkachsen eine Rotationsachse zur Ausführung von Schaltvorgängen nutzen kann. Hierzu bedient sich der Lenkstockschalter dreier Magnete, die je nach Schaltvorgang in ihrer Lage geändert oder verdreht werden. Die entsprechenden Ausgangssignale liefern hierbei Magnetsensoren, die auf die Lageänderungen oder die Verdrehung der Magnete reagieren.

Der vorliegenden Erfindung liegt die Aufgabe zugrunde, unter Verwendung des im Oberbegriff des Anspruchs 1 genannten Prinzips einen Lenkstockschalter zu schaffen, der unter Beibehaltung eines vergleichsweise einfachen Aufbaus zusätzliche Betätigungsmöglichkeiten bietet und dabei zuverlässige Betätigungs- oder Schaltsignale bereitstellt.

Diese Aufgabe wird erfindungsgemäß dadurch gelöst, dass die Kopplungsmittel derart ausgebildet sind, dass der Bedienabschnitt (16) und der Zusatzmagnet (72) relativ zu der Drehachse (18) in radialer und/oder axialer Richtung zueinander beweglich sind.

Mit dem erfindungsgemäßen Lenkstockschalter kann also nicht nur unter Verwendung des oben beschriebenen Prinzips die Schwenklage um eine oder mehrere Schwenkachsen und gegebenenfalls eine zusätzliche Tastfunktion realisiert werden. Mit dem erfindungsgemäßen Lenkstockschalter können auch weitere Funktionen abgebildet werden, die von der jeweiligen Drehlage des um eine Drehachse drehbaren Bedienabschnitts abhängen. Mit einem solchen Bedienabschnitt kann beispielsweise die Intervallschaltung einer Scheibenwischanlage des Kraftfahrzeugs angesteuert werden. Um nun die Drehlage des Bedienabschnitts erfassen zu können, ist der Bedienabschnitt mit einem zusätzlichen Magneten bewegungsgekoppelt, der mit einem zusätzlichen Magnetfeldsensor zusammenwirkt. Erfindungsgemäß ist nun vorgesehen, dass dieser Zusatzmagnetfeldsensor ebenfalls ortsfest ist, dass aber die Kopplungsmittel, die den Bedienabschnitt mit dem Zusatzmagneten verbinden, Freiheitsgrade zulassen. Die Kopplungsmittel sind derart ausgebildet, dass lediglich eine Drehkopplung zwischen dem Bedienabschnitt und dem Zusatzmagneten erfolgt, in radialer und/oder axialer Richtung der Drehachse hingegen jedoch eine Relativbewegung zugelassen wird.

Der erfindungsgemäße Aufbau hat den Vorteil, dass sowohl der Magnetfeldsensor, mit dem Erfassung der Schwenklage und gegebenenfalls auch des Abstands des mit dem Bedienhebel verschwenkbaren Magneten erfolgt, als auch der Zusatzmagnetfeldsensor unabhängig von der Schwenk- und Abstandslage des Bedienhebels und unabhängig von der Drehlage des Bedienabschnitts ortsfest angeordnet werden können.

Da der Zusatzmagnet ortsfest ist, das heißt nicht seine Position, sondern lediglich seine Drehlage ändert, bleibt der Abstand oder der Luftspalt zwischen dem Zusatzmagneten und dem Zusatzmagnetfeldsensor konstant. Hierdurch kann die Drehlage des Zusatzmagneten und somit die Drehlage des Bedienabschnitts zuverlässig erfasst werden. Darüber hinaus bietet die ortsfeste Positionierung der Magnetfeldsensoren den Vorteil einer einfachen elektrischen Kontaktierung.

Insgesamt kann mit sehr wenigen Bauteilen, insbesondere unter Verwendung einer sehr geringen Anzahl von Sensoren, eine Vielzahl von Betätigungsmöglichkeiten für einen Lenkstockschalter realisiert werden. Insbesondere ist es im günstigsten Fall mit nur zwei Magnetfeldsensoren möglich, Schwenklage des Bedienhebels, eine Tastfunktion und die Drehlage des drehbaren Bedienabschnitts erfassen zu können. Dies erfolgt sogar berührungslos, so dass nicht nur eine sehr leistungsfähige, sondern auch eine sehr zuverlässige, verschleißunempfindliche Anordnung geschaffen wird.

Um die Schwenklage des Bedienhebels besonders gut erfassen zu können, wird vorgeschlagen, dass der Magnetfeldsensor im Bereich der Schwenkachse oder im Schnittpunkt mehrerer Schwenkachsen angeordnet ist. Auf diese Weise kann erreicht werden, dass der mit dem Bedienhebel verschwenkbare Magnet entlang eines Kreisbogens um den Magnetfeldsensor verschwenkt und dabei einen konstanten Abstand zu dem Magnetfeldsensor hält. Hierdurch ist es auch möglich, eine gegebenenfalls vorgesehene Erfassung des Abstands des Magneten zu dem Magnetfeldsensor realisieren zu können und dass diese Abstandserfassung unabhängig von der aktuellen Schwenklage des Lenkstockschalters ist.

Nach einer Weiterbildung der Erfindung wird vorgeschlagen, dass der Zusatzmagnet zumindest abschnittsweise ringförmig ist. Dies ermöglicht eine raumsparende Anordnung, bei der der Zusatzmagnet konzentrisch zu dem mit dem Bedienhebel schwenkbaren Magneten angeordnet sein kann. Hierdurch kann der benötigte Bauraum minimiert werden.

Um die Drehlage des Zusatzmagneten besonders zuverlässig erfassen zu können, wird vorgeschlagen, dass dem Zusatzmagneten mindestens zwei insbesondere um 90° zueinander versetzt Zusatzmagnetfeldsensor zugeordnet sind. In diesem Fall sollte sich der Zusatzmagnet wenigstens über den Winkelversatz der zueinander versetzten Zusatzmagnetfeldsensor zuzüglich des maximalen Drehwinkels des Bedienabschnitts erstrecken.

Es wird ferner vorgeschlagen, dass der Magnetfeldsensor und der Zusatzmagnetfeldsensor oder die Zusatzmagnetfeldsensoren auf einer gemeinsamen Platine angeordnet sind. Hierdurch können die Magnetfeldsensoren als einfach montierbare Baugruppe zusammengefasst werden. Dies erleichtert auch die elektrische Kontaktierung der Magnetfeldsensoren.

In weiterer Ausgestaltung der Erfindung wird vorgeschlagen, dass die Platine an einem Trägerteil insbesondere rastend befestigt ist, das an einem Lenkstockschaltergehäuse befestigt ist. Dies ermöglicht es, mit Hilfe der die Platine umfassenden Baugruppe zusätzliche Funktionen realisieren zu können. Beispielsweise kann das Trägerteil einen Lagerabschnitt zur Drehlagerung des Zusatzmagneten aufweisen. Dies bedeutet, dass der Zusatzmagnet mit Hilfe des Trägerteil relativ zu der Platine und somit auch relativ zu dem Zusatzmagnetfeldsensor positioniert wird. Hierdurch ergibt sich eine nur sehr kleine Toleranzkette, mit der erreicht wird, dass der Luftspalt zwischen dem Zusatzmagneten und dem Zusatzmagnetfeldsensor konstant gehalten werden kann.

Es ist möglich, den Zusatzmagneten nicht direkt ortsfest zu lagern, sondern mit Hilfe eines weiteren Bauteils, beispielsweise mit Hilfe einer Drehscheibe. Mit Hilfe einer solchen Drehscheibe ist es besonders einfach, Lagerflächen zu schaffen, die beispielsweise mit dem Lagerabschnitt des Trägerteils zusammenwirken. Auf diese Weise kann auch ein direkter Reibkontakt zwischen dem Zusatzmagnetfeldsensor und einer entsprechenden Lagerstelle vermieden werden.

Für eine besonders einfache Positionierung des Zusatzmagneten kann vorgesehen sein, dass dieser von dem Material der Drehscheibe umspritzt ist. Hierdurch kann ein zusätzlicher Montageschritt eingespart werden und gleichzeitig erreicht werden, dass der Zusatzmagnet sehr genau relativ zu der Drehscheibe positioniert ist.

Zur weiteren Optimierung des Aufbaus des Lenkstockschalters wird vorgeschlagen, dass der Magnet an einer im Inneren des Bedienhebels angeordneten Welle angeordnet ist. Dies hat den Vorteil, dass sich eine weiter unten beschriebene Tastfunktion des Lenkstockschalters leichter realisieren lässt. Dabei kann der Magnet als Stabmagnet ausgebildet sein, der gegebenenfalls von dem Material der Welle umspritzt ist.

Es wird weiterhin vorgeschlagen, dass die Welle in dem Bedienhebel längsverschieblich geführt ist und an seinem dem Magneten abgewandten Ende mit einem Drücktaster betätigbar ist. Auf diese Weise lässt sich eine Bewegungskopplung zwischen einem freien Ende des Bedienhebels, an dem der Drücktaster angeordnet ist, und dem Magneten herstellen, der auf diese Weise seinen Abstand relativ zu dem Magnetfeldsensor verändert.

Besonders vorteilhaft ist es, wenn auch der drehbare Bedienabschnitt drehfest mit der Welle verbunden ist. Auf diese Weise kann die Welle benutzt werden, um die Drehbewegung von dem Bedienabschnitt hin zu dem Zusatzmagnetfeldsensor zu übertragen. Hierbei ist es hilfreich, dass die Drehlage des Magneten, dessen Schwenklage erfasst wird, für die Erfassung dieser Schwenklage oder auch des Abstands zu dem zugeordneten Magnetfeldsensor keine Rolle spielt.

Um nun die eingangs beschriebene Bewegungskopplung zwischen dem Bedienabschnitt und dem Zusatzmagneten zu realisieren, kann beispielsweise vorgesehen sein, dass die Kopplungsmittel durch eine gummielastische Membran gebildet sind. Diese Membran ist einerseits geeignet, in tangentialen Richtungen verlaufende Kräfte zu übertragen, so dass sich die Drehung des Bedienabschnitts auf eine Drehung des Zusatzmagneten überträgt. Andererseits erlaubt es die Membran, dass der Zusatzmagnet und der Bedienabschnitt in radialer und/oder axialer Richtung relativ zueinander bewegen können. Dies wiederum erlaubt es, wie eingangs bereits beschrieben, den Zusatzmagneten ortsfest lagern zu können, ohne dabei die Schwenkfunktionen des Lenkstockschalters einzuschränken.

Die Membran könnte beispielsweise durch eine im Wesentlichen flache Ringscheibe gebildet sein. Um jedoch die Beweglichkeit in radialer und/oder axialer Richtung zu erhöhen, wird vorgeschlagen, dass die Membran einen balgförmigen Abschnitt aufweist. Hiermit ist ein sich über eine erste Ebene, in der sich die Membran erstreckt, hervorstehender Materialabschnitt gemeint, mit dem in einem vergleichsweise eng begrenzten Bauraum relativ viel Material bereitgestellt wird, das sich für die gewünschte Beweglichkeit in radialer und/oder axialer Richtung verformen kann.

Eine Weiterbildung der Erfindung sieht vor, dass die Welle, die Membran und die Drehscheibe als Verbundwerkstoff hergestellt sind, wobei die Welle und die Drehscheibe aus einem harten Werkstoff oder aus harten Werkstoffen gebildet sind und die Membran aus einem weichen Werkstoff gebildet ist. Ein solcher Verbundwerkstoff kann beispielsweise mit Hilfe eines Mehrkomponentenspritzgussverfahrens hergestellt werden und hat neben einer wirtschaftlichen Fertigung den Vorteil, dass Welle, Membran und Drehscheibe bereits mit Herstellung des Verbundteils genau zueinander positioniert sind. Hierbei bietet es sich an, auch den Magneten und/oder den Zusatzmagneten mit einzuspritzen, so dass weitere Montageschritte entfallen können.

Die Kopplungsmittel können auch eine Kupplung umfassen, die auf dem Oldham-Prinzip basiert. Eine solche Kupplung zeichnet sich dadurch aus, dass die Drehbewegung eines ersten Wellenstücks sich auf ein zweites Wellenstück übertragen lässt, das relativ zu dem ersten Wellenstück einen axialen Versatz aufweist.

Zur Optimierung dieses Prinzips wird vorgeschlagen, dass die Kopplungsmittel ein Ausgleichselement aufweisen, das über ein Schubgelenk mit dem Zusatzmagneten oder der Drehscheibe gekoppelt ist und das über ein Drehschubgelenk mit dem Bedienhebel oder mit der Welle des Bedienhebels gekoppelt ist. Auf diese Weise können die für eine Schwenkbewegung des Bedienhebels und gleichzeitiger Erfassung der Drehstellung des Bedienabschnitts erforderlichen Freiheitsgrade geschaffen werden.

Weitere Vorteile, Merkmale und Einzelheiten der Erfindung ergeben sich aus der nachfolgenden Beschreibung, in der unter Bezugnahme auf die Zeichnung besonders bevorzugte Ausführungsbeispiele im Einzelnen beschrieben sind. Dabei können die in der Zeichnung gezeigten sowie in den Ansprüchen sowie in der Beschreibung erwähnten Merkmale jeweils einzeln für sich oder in beliebiger Kombination erfindungswesentlich sein. In der Zeichnung zeigen:
- Figur 1: eine perspektivische Ansicht eines Lenkstockschalters;
- Figur 2: eine Explosionsansicht des Lenkstockschalters;
- Figuren 3a und 3b: eine perspektivische Ansicht einer vor- bzw. fertigmontierten Baugruppe des Lenkstockschalters;
- Figur 4: eine Schnittansicht des Lenkstockschalters;
- Figur 5: eine perspektivische Ansicht eines Teilbereichs des Lenkstockschalters;
- Figuren 6a und 6b: perspektivische Ansichten verschiedener Bauteile des in Figur 5 dargestellten Teilbereichs des Lenkstockschalters;
- Figur 7: eine perspektivische Ansicht mit Magnet, Magnetfeldsensor, Zusatzmagnet und Zusatzmagnetfeldsensor des Lenkstockschalters;
- Figur 8: eine Darstellung des von dem Zusatzmagnetfeldsensor in Abhängigkeit der Drehlage des Zusatzmagneten erzeugten Signalverlaufs; und
- Figur 9: eine perspektivische Ansicht eines Teilbereichs des Lenkstockschalters gemäß einer weiteren Ausführungsform.

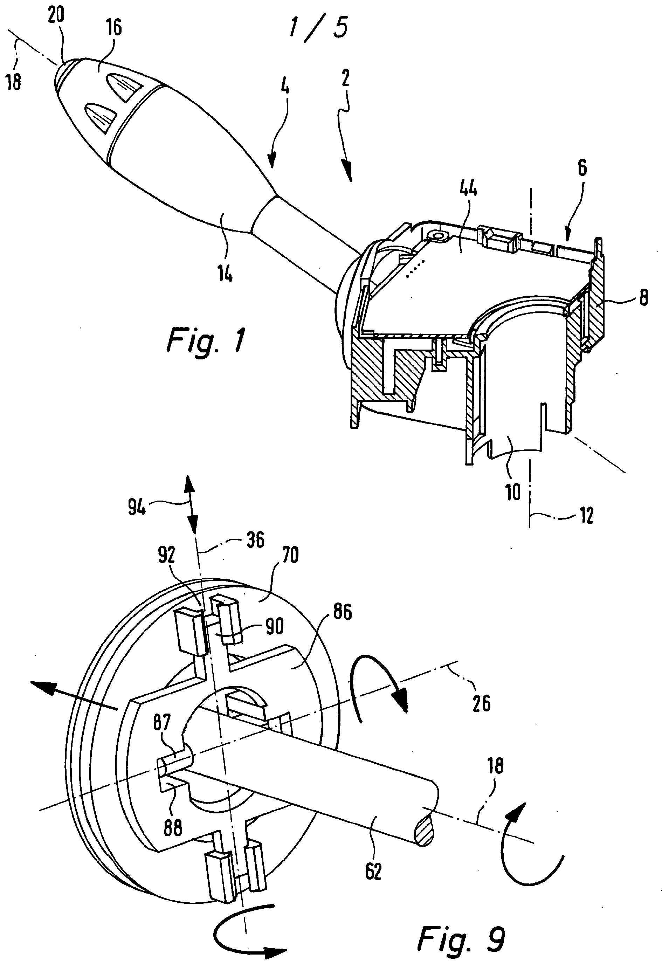

In Figur 1 ist ein Lenkstockschalter insgesamt mit dem Bezugszeichen 2 bezeichnet. Dieser weist einen länglichen Bedienhebel 4 auf, der an einem Gehäuse 6 gelagert ist. Das Gehäuse 6 weist ein Gehäuseteil 8 auf, in dem ein in Figur 1 nur abschnittsweise dargestellter Durchbruch 10 vorgesehen ist, um den Durchtritt einer nicht dargestellten Lenkwelle zu erlauben. In Figur 1 ist die Lenkwellenachse mit dem Bezugszeichen 12 bezeichnet.

Der Bedienhebel 4 weist ein rohrartiges Hebelgehäuse 14 auf, das von einer Bedienperson ergriffen werden kann und um verschiedene Schwenkachsen, die weiter unten noch erläutert werden, verschwenkbar ist.

An dem dem Gehäuse 6 abgewandten Ende des Bedienhebels 4 ist ein Bedienabschnitt 16 vorgesehen, der um eine Drehachse 18 verdrehbar ist. Dabei entspricht die Drehachse 18 zumindest in etwa einer zentralen Längsachse des Bedienhebels 4. Mit Hilfe des Bedienabschnitts 16 lässt sich beispielsweise die Intervallschaltung eines Scheibenwischers ansteuern.

Benachbart zu dem Bedienabschnitt 16 weist der Bedienhebel 4 an seinem freien Ende einen Drücktaster 20 auf. Mit diesem kann eine weitere Funktion, beispielsweise eine Hupe oder eine Wischwasserfunktion angesteuert werden.

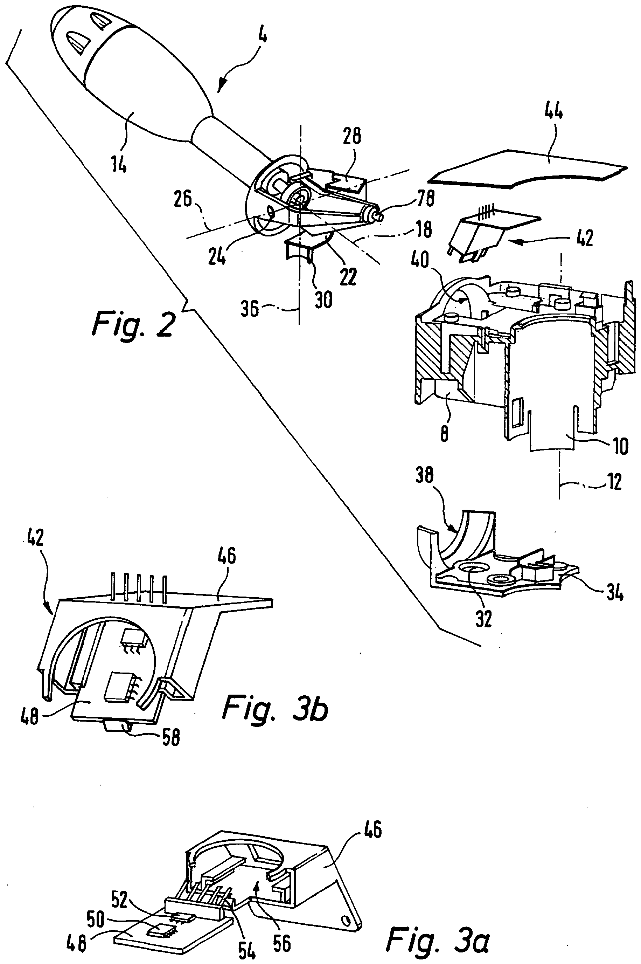

Mit weiterem Bezug auf Figur 2 ist das Hebelgehäuse 14 des Bedienhebels 4 einstückig mit einem Lagerblock 22 ausgebildet, der zwei einander gegenüberliegende Lagerstellen 24 aufweist, von denen in Figur 2 nur eine dargestellt ist. Diese Lagerstellen definieren eine Schwenkachse 26, um die der Bedienhebel 4 herum verschwenkbar ist. Beim Verschwenken des Bedienhebels 4 um die Schwenkachse 26 kann beispielsweise eine Lichthupenfunktion und eine Fernlichtfunktion eines Kraftfahrzeugs realisiert werden.

Der Lagerblock 22 ist in einem mit 28 bezeichneten Mitnehmer gelagert, der wiederum eine Lagerstelle 30 aufweist, die zum Eingriff in eine Lageraufnahme 32 ausgebildet ist, die in einem Gehäusedeckel 34 vorgesehen ist. Der Gehäusedeckel 34 ist Teil des in Figur 1 insgesamt mit dem Bezugszeichen 6 bezeichneten Gehäuses des Lenkstockschalters 2. Die Lagerstelle 30 und die Lageraufnahme 32 definieren gemeinsam mit einer weiter oberhalb angeordneten, in der Zeichnung nicht dargestellten Lagerung eine Schwenkachse 36, die die Schwenkachse 26 vorzugsweise in einem rechten Winkel schneidet. Bei Verschwenken des Bedienhebels 4 um die Schwenkachse 36 kann beispielsweise eine Blinklichtfunktion des Kraftfahrzeugs realisiert werden.

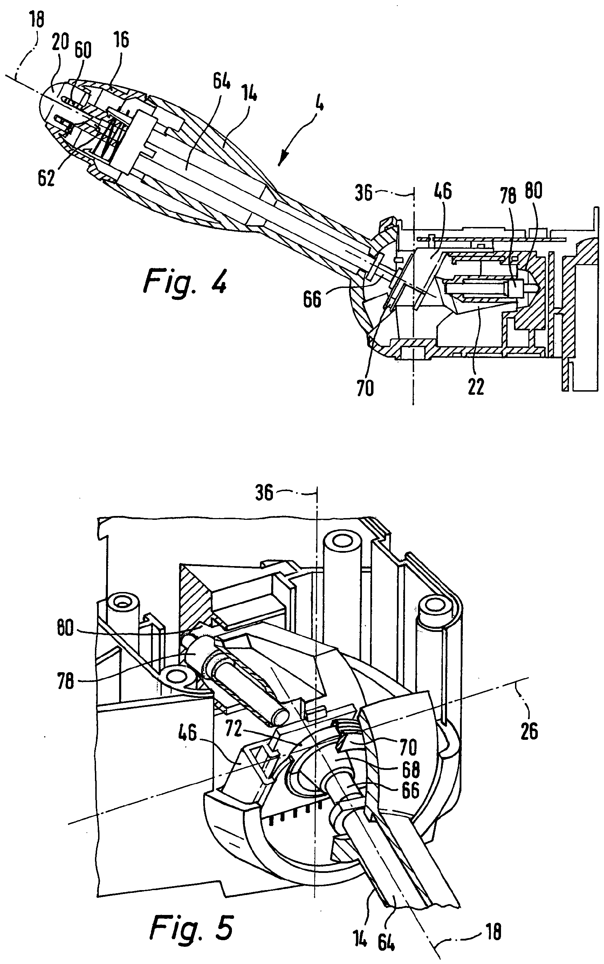

Sowohl der Gehäusedeckel 34 als auch das Gehäuseteil 8 weisen in etwa halbkreisförmige Aussparungen 38 und 40 auf, die insgesamt im montierten Zustand (vergleiche Figuren 1 und 4) einen in etwa kreisförmigen Durchbruch begrenzen, durch den der Bedienhebel 4 ragt.

Gemäß Figur 2 umfasst der Lenkstockschalter 2 außerdem eine Baugruppe 42 sowie eine Hauptplatine 44, die im montierten Zustand auch in Figur 1 dargestellt ist. Die Baugruppe 42 wird im Folgenden mit Bezug auf Figuren 3a und 3b beschrieben. Die Baugruppe 42 weist ein Trägerteil 46 auf, das fest mit dem Gehäuseteil 8 verbunden werden kann, beispielsweise durch eine geeignete Verrastung. Die Baugruppe 42 umfasst ferner eine Platine 48, auf der ein Magnetfeldsensor 50 sowie ein Zusatzmagnetfeldsensor 52 angeordnet sind. Die Magnetfeldsensoren 50 und 52 sind über Kontaktelemente 54 elektrisch kontaktiert und an eine Spannungsversorgung beziehungsweise an entsprechende Datenleitungen des Kraftfahrzeugs angeschlossen.

Zur Montage der Baugruppe 42 kann die Platine 48 in eine an dem Trägerteil 46 ausgebildete Aufnahme 56 eingeschoben und dort mit Hilfe eines Rastelements 58 (vergleiche Figur 3b) gesichert werden.

Figur 4 zeigt den Lenkstockschalter 2 in einer Schnittansicht. Der Drücktaster 20 ist mit Hilfe einer Feder 60 in seiner Grundstellung gehalten. Der Drücktaster 20 wirkt auf eine sich durch das Hebelgehäuse 14 hindurcherstreckende Welle 62, die in einer länglichen Führung 64 längsverschieblich geführt ist. Die Welle 62 mündet an ihrem dem Drücktaster 20 abgewandten Ende an einem Wellenende 66, das in Figur 5 aus einer anderen Perspektive dargestellt ist.

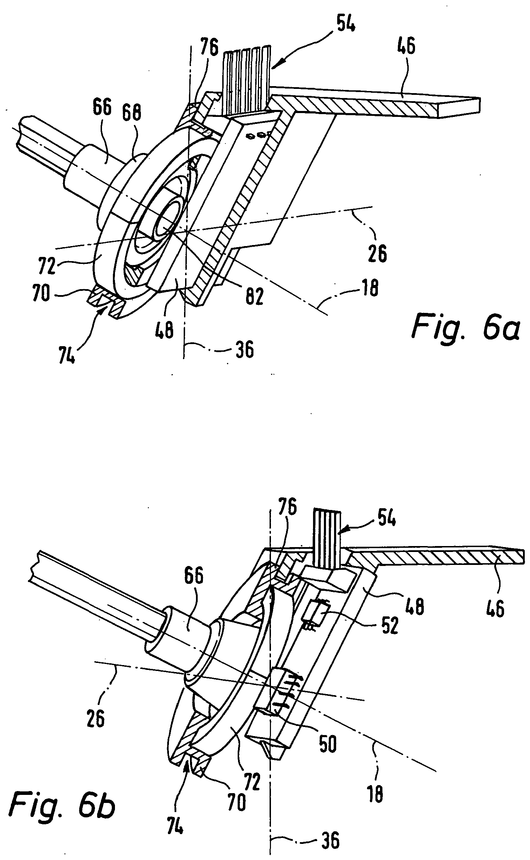

Mit weiteren Bezug auf Figur 5 ist das Wellenende 66 mit einer Membran 68, die aus einem gummielastischen Material gebildet ist, verbunden. Die Membran 68 wiederum ist mit einer sich um die Membran 68 herum erstreckende Drehscheibe verbunden. Hierfür ist der Rand der Membran 68 in dem Material der Drehscheibe 70 eingefasst (vergleiche Figur 6a). In die Drehscheibe 70 ist ein ringförmiger Zusatzmagnet 72 eingespritzt.

Die Drehscheibe 70 weist eine in den Figuren 6a und 6b mit 74 bezeichnete Nut auf. In diese Nut greift ein an dem Trägerteil 46 Lagerabschnitt 76 ein. Auf diese Weise ist die Drehscheibe 70 und somit auch der Zusatzmagnet 72 drehbar an dem Trägerteil 46 gelagert.

Der Bedienabschnitt 16 (vergleiche Figur 4) ist über die Führung 64 drehfest mit der Welle 62 verbunden. Dies kann durch eine entsprechende formschlüssige Verbindung der genannten Bauteile erreicht werden. Wird also der Bedienabschnitt 16 um die Drehachse 18 verdreht, dreht sich die Führung 64 mit, so dass sich auch die Welle 62 mitdreht. Hierdurch wird die am Wellenende 66 befestigte Membran mit verdreht, hierdurch wiederum die Drehscheibe 70 und somit auch der Zusatzmagnet 72.

Wird der beispielsweise in den Figuren 2 und 4 dargestellte Bedienhebel 4 um eine oder beide der Schwenkachsen 26 und 36 verschwenkt, bewegen sich die Führung 64 sowie die Welle 66 entsprechend mit. Der Bedienhebel 4 kann tastend betätigt werden, indem er aus einer Mittellage heraus in eine verschwenkte Lage gebracht wird und aus dieser selbsttätig zurückfedert. Es ist auch möglich, dass der Bedienhebel 4 in bevorzugten Schwenklagen eingerastet werden kann. Hierfür ist an dem freien Ende des Lagerblocks 22 ein federbetätigtes Schaltstück 78 vorgesehen, das in eine gehäusefeste Schaltkulisse 80 greift.

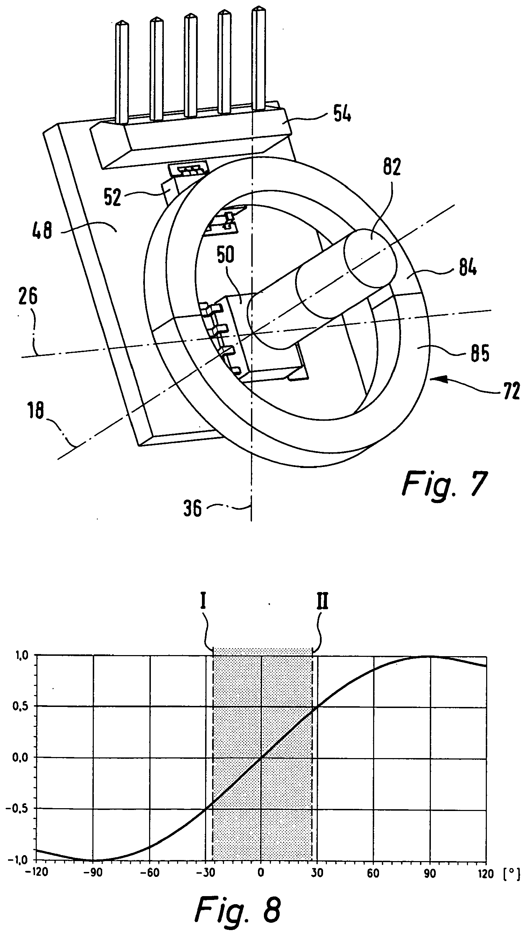

Um die Schwenklagen des Bedienhebels 4 detektieren zu können, weist die Welle 62 an ihrem Wellenende 66 einen Magneten 82 auf, der in Figur 7 ohne das Wellenende 66 dargestellt ist. Bei einem Verschwenken des Bedienhebels 4 wird der Stabmagnet 82 um die Schwenkachsen 26 beziehungsweise 36 verschwenkt. Hierdurch ändert sich die Lage des Magneten 82 relativ zu dem ortsfesten Magnetfeldsensor 50. Der Magnetfeldsensor 50 kann beispielsweise als Sensor des Typs "MLX 90316" der Firma Melexis ausgebildet sein. Der Magnetfeldsensor 50 ist im Bereich des Schnittpunkts der Schwenkachsen 26 und 36 angeordnet. Wird der Bedienhebel 4 um eine dieser Achsen verschwenkt, bewegt sich der Magnet 82 entsprechend mit und schwenkt kreisbogenförmig um den Magnetfeldsensor 50 herum. Der Magnetfeldsensor 50 ist nun in der Lage, die durch sich durch die unterschiedlichen Schwenklagen des Magneten 82 ergebenden Veränderungen des Magnetfelds zu detektieren, so dass die Schwenklage des Bedienhebels 4 bestimmt werden kann.

Die Drehlage des Bedienabschnitts 16 hingegen kann aus der Erfassung der Drehlage des Zusatzmagneten 72 hergeleitet werden. In dem dargestellten Ausführungsbeispiel weist der Zusatzmagnet 72 zwei sich jeweils über 180 Winkelgrad erstreckende, gegenpolige Magnetabschnitte 84 und 85 auf. Hierzu direkt benachbart ist der Zusatzmagnetfeldsensor 52 auf der Platine 48 positioniert, so dass mit diesem Sensor eine sich durch die Veränderung der Drehlage des Zusatzmagneten 72 ergebende Änderung des Magnetfeldes detektiert werden kann. Wird der Zusatzmagnet 72 um die Drehachse 18 verdreht, ergibt sich für eine in Figur 8 dargestellte normierte Feldstärke ein sinusförmiges Signal. Ein Teilbereich dieses sinusförmigen Verlaufs, der in Figur 8 durch die Drehlagen I und II begrenzt ist, weist einen in etwa linear ansteigenden Signalverlauf auf. Dieser Winkelbereich ist besonders gut zur Erfassung von entsprechenden Drehlagen des Bedienabschnitts 16 geeignet. Sollte es erwünscht sein, die Drehlage des Bedienabschnitts 16 über mehr als einen Winkelbereich von 180° detektieren zu wollen, ist es auch möglich, zwei Zusatzmagnetfeldsensoren 52 vorzusehen, die vorzugsweise um 90° zueinander winkelversetzt sind. Diese erzeugen dann zwei zueinander um 90° versetzte Sinussignale, aus denen ein über einen Winkelbereich von 360° linear ansteigendes Arcus-Tangens-Signal hergeleitet werden kann.

Figur 9 zeigt eine weitere Möglichkeit, die Welle 62 mit der Drehscheibe 70 zu verbinden. Anstelle der Membran 68 ist ein Ausgleichselement 86 vorgesehen. Dieses wirkt über ein Drehschubgelenk mit der Welle 62 zusammen. Hierfür weist die Welle 62 zwei einander gegenüberliegende Bolzen 87 auf, die jeweils in eine Führung 88 eingreifen, die an dem Ausgleichselement 86 ausgebildet ist.

Das Ausgleichselement 86 weist ferner in um 90° zu den Positionen der Führungen 88 versetzten Lagen Zapfen 90 auf, die in an der Drehscheibe 70 ausgebildete Zapfenaufnahmen 92 greifen. Die Zapfen 90 sind in den Zapfenaufnahmen 92 in mit 94 bezeichneten Richtungen verschiebbar, so dass mit Hilfe der Zapfen 90 und der Zapfenaufnahmen 92 ein Schubgelenk gebildet wird.

Die in Figur 9 dargestellte Anordnung kann in einen mit Bezug auf die Figuren 1 - 8 dargestellten Lenkstockschalter eingebaut werden. Dabei ersetzt die Anordnung gemäß Figur 9 die Membran 68. Dementsprechend ist auch an dem Ende der in Figur 9 dargestellten Welle 62 ein Magnet 82 angeordnet.

Die Anordnung gemäß Figur 9 ermöglicht es nun, eine Drehbewegung des Bedienabschnitts 16 um die Drehachse 18 auf die Drehscheibe 70 und somit auch auf den Zusatzmagneten 72 zu übertragen. Hierbei nimmt die durch Verdrehung des Bedienabschnitts 16 um die Drehachse 18 rotierende Welle 62 über die Bolzen 87 und die Führung 88 das Ausgleichselement 86 rotatorisch mit. Über die Zapfen 90 und die Zapfenaufnahmen 92 überträgt sich diese Drehbewegung auf die Drehscheibe 70 und somit auf den Zusatzmagneten 72.

Wird der Bedienhebel 4 mit der Welle 62 um die Schwenkachse 26 verschwenkt, kann das Ausgleichselement 86 in mit 94 bezeichneten Richtungen translatorisch bewegt werden. Bei Verschwenken des Bedienhebels 4 beziehungsweise der Welle 62 um die Schwenkachse 36 können die Bolzen 87 sich frei in der Führung 88 bewegen. Schließlich kann die Welle 62 mit Hilfe des Drücktasters 20 entlang der Drehachse 18 verschoben werden. Hierbei gleiten die Bolzen 87 innerhalb der Führung 88.

Der beschriebene Aufbau ermöglicht es, dass trotz der ortsfesten Lagerung der Zusatzmagneten 72 der Bedienhebel 4 um die Schwenkachsen 26 und 36 verschwenkt werden kann. Durch die Erfassung der Schwenklage des der Welle 62 zugeordneten Magneten 82 kann somit die Schwenklage des Bedienhebels 4 mit Hilfe des Magnetfeldsensors 50 erfasst werden. Da die Welle 62 auch translatorisch entlang der Drehachse 18 bewegt werden kann, ist auch eine Erfassung des Abstands zwischen dem Magneten 82 und dem ortsfesten Magnetfeldsensor 50 möglich, so dass auch die Funktion des Drücktasters 20 abgefragt werden kann.

## Patentansprüche

1. Lenkstockschalter (2) für Kraftfahrzeuge, mit einem um mindestens eine Schwenkachse (26, 36) schwenkbaren Bedienhebel (4), mit einem mit dem Bedienhebel (4) verschwenkbaren Magneten (82), der mit einem ortsfesten Magnetfeldsensor (50) zusammenwirkt, wobei der Magnetfeldsensor (50) so ausgebildet ist, dass die Schwenklage des Magneten (82) und/oder verschiedene Abstände des Magneten (82) zu dem Magnetfeldsensor (50) bestimmbar ist oder sind, wobei der Bedienhebel (4) einen relativ zu dem Bedienhebel (4) um eine Drehachse (18) drehbaren Bedienabschnitt (16) aufweist, der über Kopplungsmittel mit einem Zusatzmagneten (72) bewegungsgekoppelt ist, der mit mindestens einem ortsfesten Zusatzmagnetfeldsensor (52) zusammenwirkt, und wobei die Kopplungsmittel derart ausgebildet sind, dass der Bedienabschnitt (16) und der Zusatzmagnet (72) miteinander drehgekoppelt sind, **dadurch gekennzeichnet, dass** die Kopplungsmittel derart ausgebildet sind, dass der Bedienabschnitt (16) und der Zusatzmagnet (72) relativ zu der Drehachse (18) in radialer (94) und/oder axialer Richtung zueinander beweglich sind.

2. Lenkstockschalter (2) nach Anspruch 1, **dadurch gekennzeichnet, dass** der Magnetfeldsensor (50) im Bereich der Schwenkachse (26, 36) oder im Schnittpunkt mehrerer Schwenkachsen (26, 36) angeordnet ist.

3. Lenkstockschalter (2) nach Anspruch 1 oder 2, **dadurch gekennzeichnet, dass** der Zusatzmagnet (72) zumindest abschnittsweise ringförmig ist.

4. Lenkstockschalter (2) nach mindestens einem der vorhergehenden Ansprüche, **dadurch gekennzeichnet, dass** dem Zusatzmagneten (72) mindestens zwei insbesondere um 90° zueinander versetzte Zusatzmagnetfeldsensoren (52) zugeordnet sind.

5. Lenkstockschalter (2) nach mindestens einem der vorhergehenden Ansprüche, **dadurch gekennzeichnet, dass** der Magnetfeldsensor (50) und der Zusatzmagnetfeldsensor (52) oder die Zusatzmagnetfeldsensoren auf einer gemeinsamen Platine (48) angeordnet sind.

6. Lenkstockschalter (2) nach Anspruch 5, **dadurch gekennzeichnet, dass** die Platine (48) an einem Trägerteil (46) insbesondere rastend befestigt ist, das an einem Lenkstockschaltergehäuse (6) befestigt ist.

7. Lenkstockschalter (2) nach Anspruch 6, **dadurch gekennzeichnet, dass** das Trägerteil (46) einen Lagerabschnitt (76) zur Drehlagerung des Zusatzmagneten (72) aufweist.

8. Lenkstockschalter (2) nach Anspruch 7, **dadurch gekennzeichnet, dass** der Zusatzmagnet (72) an einer Drehscheibe (70) angeordnet ist.

9. Lenkstockschalter (2) nach Anspruch 8, **dadurch gekennzeichnet, dass** die Drehscheibe (70) an dem Lagerabschnitt (76) gelagert ist.

10. Lenkstockschalter (2) nach Anspruch 8 oder 9, **dadurch gekennzeichnet, dass** der Zusatzmagnet (72) von dem Material der Drehscheibe (70) umspritzt ist.

11. Lenkstockschalter (2) nach mindestens einem der vorhergehenden Ansprüche, **dadurch gekennzeichnet, dass** der Magnet (82) an einer im Inneren des Bedienhebels (4) angeordneten Welle (62) angeordnet ist.

12. Lenkstockschalter (2) nach mindestens einem der vorhergehenden Ansprüche, **dadurch gekennzeichnet, dass** der Magnet (82) als Stabmagnet ausgebildet ist.

13. Lenkstockschalter (2) nach Anspruch 11 oder 12, **dadurch gekennzeichnet, dass** der Magnet (82) von dem Material der Welle (62) umspritzt ist.

14. Lenkstockschalter (2) nach mindestens einem der Ansprüche 11 bis 13, **dadurch gekennzeichnet, dass** die Welle (62) in dem Bedienhebel (4) längs verschieblich geführt ist und an seinem dem Magneten (82) abgewandten Ende mit einem Drücktaster (20) betätigbar ist.

15. Lenkstockschalter (2) nach mindestens einem der Ansprüche 11 bis 14, **dadurch gekennzeichnet, dass** der Bedienabschnitt (16) drehfest mit der Welle (62) verbunden ist.

16. Lenkstockschalter (2) nach mindestens einem der vorhergehenden Ansprüche, **dadurch gekennzeichnet, dass** die Kopplungsmittel durch eine gummielastische Membran (68) gebildet sind.

17. Lenkstockschalter (2) nach Anspruch 16, **dadurch gekennzeichnet, dass** die Membran (68) einen balgförmigen Abschnitt aufweist.

18. Lenkstockschalter (2) nach Anspruch 16 oder 17, **dadurch gekennzeichnet, dass** die Welle (62), die Membran (68) und die Drehscheibe (70) als Verbundwerkstück hergestellt sind, wobei die Welle (62) und die Drehscheibe (70) aus einem harten Werkstoff oder aus harten Werkstoffen gebildet sind und die Membran (68) aus einem weichen Werkstoff gebildet ist.

19. Lenkstockschalter (2) nach mindestens einem der vorhergehenden Ansprüche, **dadurch gekennzeichnet, dass** die Kopplungsmittel eine Kupplung umfassen, die auf dem Oldham-Prinzip basiert.

20. Lenkstockschalter (2) nach mindestens einem der vorhergehenden Ansprüche, **dadurch gekennzeichnet, dass** die Kopplungsmittel ein Ausgleichselement (86) aufweisen, das über ein Schubgelenk mit dem Zusatzmagneten (72) oder der Drehscheibe (70) gekoppelt ist und das über ein Drehschubgelenk mit dem Bedienhebel (4) oder mit der Welle (62) des Bedienhebels (4) gekoppelt ist.

## Claims

1. Steering-column switch (2) for motor vehicles, with an operating lever (4) which is pivotable about at least one pivot axis (26, 36), with a magnet (82) which can be pivoted by the operating lever (4) and interacts with a positionally fixed magnetic field sensor (50), wherein the magnetic field sensor (50) is designed in such a manner that the pivoted position of the magnet (82) with respect to the magnetic field sensor (50) and/or different distances of the magnet (82) therefrom can be determined, wherein the operating lever (4) has an operating portion (16) which is rotatable about an axis of rotation (18) relative to the operating lever (4) and is coupled in terms of movement via coupling means to an additional magnet (72) which interacts with at least one positionally fixed additional magnetic field sensor (52), and wherein the coupling means are designed in such a manner that the operating portion (16) and the additional magnet (72) are rotationally coupled to one another, **characterized in that** the coupling means are designed in such a way that the operating portion (16) and the additional magnet (72) are movable in the radial and/or axial direction with respect to one another relative to the axis of rotation (18).

2. Steering-column switch (2) according to Claim 1, **characterized in that** the magnetic field sensor (50) is arranged in the region of the pivot axis (26, 36) or at the point of intersection of a number of pivot axes (26, 36).

3. Steering-column switch (2) according to Claim 1 or 2, **characterized in that** the additional magnet (72) is at least partly annular.

4. Steering-column switch (2) according to at least one of the preceding claims, **characterized in that** the additional magnet (72) is assigned at least two additional magnetic field sensors (52), which are in particular offset by 90° in relation to one another.

5. Steering-column switch (2) according to at least one of the preceding claims, **characterized in that** the magnetic field sensor (50) and the additional magnetic field sensor (52) or the additional magnetic field sensors are arranged on a common plate (48).

6. Steering-column switch (2) according to Claim 5, **characterized in that** the plate (48) is fastened, in particular in a locking manner, to a carrier part (46), which is fastened to a steering-column switch housing (6).

7. Steering-column switch (2) according to Claim 6, **characterized in that** the carrier part (46) has a bearing portion (76) for the rotational mounting of the additional magnet (72).

8. Steering-column switch (2) according to Claim 7, **characterized in that** the additional magnet (72) is arranged on a rotary disc (70).

9. Steering-column switch (2) according to Claim 8, **characterized in that** the rotary disc (70) is mounted on the bearing portion (76).

10. Steering-column switch (2) according to Claim 8 or 9, **characterized in that** the additional magnet (72) is encapsulated by the material of the rotary disc (70).

11. Steering-column switch (2) according to at least one of the preceding claims, **characterized in that** the magnet (82) is arranged on the shaft (62) arranged inside the operating lever (4).

12. Steering-column switch (2) according to at least one of the preceding claims, **characterized in that** the magnet (82) is formed as a bar magnet.

13. Steering-column switch (2) according to Claim 11 or 12, **characterized in that** the magnet (82) is encapsulated by the material of the shaft (62).

14. Steering-column switch (2) according to at least one of Claims 11 to 13, **characterized in that** the shaft (62) is guided longitudinally displaceably in the operating lever (4) and can be actuated by a pushbutton (20) at its end remote from the magnet (82).

15. Steering-column switch (2) according to at least one of Claims 11 to 14, **characterized in that** the operating portion (16) is connected to the shaft (62) for rotation therewith.

16. Steering-column switch (2) according to at least one of the preceding claims, **characterized in that** the coupling means are formed by a rubber-elastic membrane (68).

17. Steering-column switch (2) according to Claim 16, **characterized in that** the membrane (68) has a bellows-shaped portion.

18. Steering-column switch (2) according to Claim 16 or 17, **characterized in that** the shaft (62), the membrane (68) and the rotary disc (70) are produced as a composite workpiece, wherein the shaft (62) and the rotary disc (70) are formed from a hard material or from hard materials and the membrane (68) is formed from a soft material.

19. Steering-column switch (2) according to at least one of the preceding claims, **characterized in that** the coupling means comprise a coupling that is based on the Oldham principle.

20. Steering-column switch (2) according to at least one of the preceding claims, **characterized in that** the coupling means have a compensating element (86), which is coupled via a sliding joint to the additional magnet (72) or the rotary disc (70) and which is coupled via a turning-and-sliding joint to the operating lever (4) or to the shaft (62) of the operating lever (4).

## Revendications

1. Commutateur de colonne de direction (2) pour véhicules automobiles, avec un levier de commande (4) pouvant pivoter autour d'au moins un axe de pivotement (26, 36), avec un aimant (82) pouvant pivoter avec le levier de commande (4), qui coopère avec un détecteur de champ magnétique fixe (50), dans lequel le détecteur de champ magnétique (50) est configuré de telle manière que la position de pivotement de l'aimant (82) et/ou différentes distances de l'aimant (82) au détecteur de champ magnétique (50) puisse ou puissent être déterminée(s), dans lequel le levier de commande (4) présente une partie de commande (16) pouvant tourner autour d'un axe de rotation (18) par rapport au levier de commande (4), qui est cinématiquement couplée par des moyens de couplage à un aimant supplémentaire (72), qui coopère avec au moins un détecteur de champ magnétique supplémentaire fixe (52), et dans lequel les moyens de couplage sont configurés de telle manière que la partie de commande (16) et l'aimant supplémentaire (72) soient couplés l'un à l'autre en rotation, **caractérisé en ce que** les moyens de couplage sont configurés de telle manière que la partie de commande (16) et l'aimant supplémentaire (72) soient mobiles l'un par rapport à l'autre en direction radiale (94) et/ou en direction axiale par rapport à l'axe de rotation (18).

2. Commutateur de colonne de direction (2) selon la revendication 1, **caractérisé en ce que** le détecteur de champ magnétique (50) est disposé dans la région de l'axe de pivotement (26, 36) ou au point d'intersection de plusieurs axes de pivotement (26, 36).

3. Commutateur de colonne de direction (2) selon la revendication 1 ou 2, **caractérisé en ce que** l'aimant supplémentaire (72) est au moins en partie de forme annulaire.

4. Commutateur de colonne de direction (2) selon au moins une des revendications précédentes, **caractérisé en ce qu'**au moins deux détecteurs de champ magnétique supplémentaires (52) décalés en particulier de 90° l'un par rapport à l'autre sont associés à l'aimant supplémentaire (72).

5. Commutateur de colonne de direction (2) selon au moins une des revendications précédentes, **caractérisé en ce que** le détecteur de champ magnétique (50) et le détecteur de champ magnétique supplémentaire (52) ou les détecteurs de champ magnétique supplémentaires sont disposés sur une platine commune (48).

6. Commutateur de colonne de direction (2) selon la revendication 5, **caractérisé en ce que** la platine (48) est fixée, en particulier par encliquetage, à une partie de support (46), qui est fixée à un boîtier de commutateur de colonne de direction (6).

7. Commutateur de colonne de direction (2) selon la revendication 6, **caractérisé en ce que** la partie de support (46) présente une partie de palier (76) pour le support tournant de l'aimant supplémentaire (72).

8. Commutateur de colonne de direction (2) selon la revendication 7, **caractérisé en ce que** l'aimant supplémentaire (72) est disposé sur un disque rotatif (70) .

9. Commutateur de colonne de direction (2) selon la revendication 8, **caractérisé en ce que** le disque rotatif (70) est monté sur la partie de palier (76).

10. Commutateur de colonne de direction (2) selon la revendication 8 ou 9, **caractérisé en ce que** l'aimant supplémentaire (72) est enrobé par le matériau du disque rotatif (70).

11. Commutateur de colonne de direction (2) selon au moins une des revendications précédentes, **caractérisé en ce que** l'aimant (82) est disposé sur un arbre (62) agencé à l'intérieur du levier de commande (4).

12. Commutateur de colonne de direction (2) selon au moins une des revendications précédentes, **caractérisé en ce que** l'aimant (82) est configuré en forme de barreau magnétique.

13. Commutateur de colonne de direction (2) selon la revendication 11 ou 12, **caractérisé en ce que** l'aimant (82) est enrobé avec le matériau de l'arbre (62).

14. Commutateur de colonne de direction (2) selon au moins une des revendications 11 à 13, **caractérisé en ce que** l'arbre (62) est guidé en mouvement longitudinal dans le levier de commande (4) et peut être actionné avec un bouton poussoir (20) à son extrémité opposée à l'aimant (82).

15. Commutateur de colonne de direction (2) selon au moins une des revendications 11 à 14, **caractérisé en ce que** la partie de commande (16) est calée en rotation avec l'arbre (62).

16. Commutateur de colonne de direction (2) selon au moins une des revendications précédentes, **caractérisé en ce que** les moyens de couplage sont formés par une membrane élastique en caoutchouc (68).

17. Commutateur de colonne de direction (2) selon la revendication 16, **caractérisé en ce que** la membrane (68) présente une partie en forme de soufflet.

18. Commutateur de colonne de direction (2) selon la revendication 16 ou 17, **caractérisé en ce que** l'arbre (62), la membrane (68) et le disque rotatif (70) sont fabriqués sous forme de pièce composite, dans lequel l'arbre (62) et le disque rotatif (70) sont formés en un matériau dur ou en matériaux durs et la membrane (68) est formée en un matériau souple.

19. Commutateur de colonne de direction (2) selon au moins une des revendications précédentes, **caractérisé en ce que** les moyens de couplage comprennent un accouplement, qui est basé sur le principe d'Oldham.

20. Commutateur de colonne de direction (2) selon au moins une des revendications précédentes, **caractérisé en ce que** les moyens de couplage présentent un élément de compensation (86), qui est couplé par un joint à glissière à l'aimant supplémentaire (72) ou au disque rotatif (70) et qui est couplé par un joint articulé cylindrique au levier de commande (4) ou à l'arbre (62) du levier de commande (4).
